# EUROPEAN PATENT SPECIFICATION

(11) **EP 0 356 909 B1**
(45) Date of publication and mention of the grant of the patent: **03.05.1995**
(21) Application number: 89115605.1
(22) Date of filing: 24.08.1989
(51) Int. Cl.: H03K 3/289

(54) **Small area and low current drain frequency divider cell for integrated circuits**
Frequenzteilerzelle mit geringem Flächenbedarf und geringer Stromaufnahme für integrierte Schaltungen
Cellule de diviseur de fréquence à faible surface et à faible absorption de courant pour circuits intégrés

(30) Priority: 31.08.1988 IT 2179188
(43) Date of publication of application: 07.03.1990
(73) Proprietor: SGS-THOMSON MICROELECTRONICS s.r.l., 20041 Agrate Brianza (Milano) (IT)
(72) Inventor: Menegoli, Paolo, San Pietro In Cariano Verona (IT); Morelli, Marco, I-57100 Livorno (IT); Tricoli, Francesco, I-20153 Milano (IT)
(74) Representative: Forattini, Amelia

(56) References cited:
- US-A- 3 767 943
- PATENT ABSTRACTS OF JAPAN, vol. 7, no. 280 (E-216)[1425], 14th December 1983;& JP-A-58 159 021
- NEUE UHRMACHER ZEITUNG, vol. 25, May 1971, pages 22-24, Ulm, DE; A. GREUTER et al.: "Neuartiger Frequenzteiler für elektronische Armbanduhren"

## Description

The present invention relates to a small area and low current drain frequency divider cell for Integrated Circuits.

As is known, electric low frequency signals are usually generated through the use of very high RC time constants, which are very difficult to be obtained in IC's, in which large capacity and/or resistance values are not available. Thus, as a low frequency signal is required in an IC, it is preferred to generate a higher frequency signal and reduce successively the frequency thereof by means of a divider comprising a plurality of cascade coupled master-slave flip-flop cells each of which provides a division by two.

Each of these divider cells typically comprises, in addition to several transistors, also several resistors and, accordingly, each cell will occupy a comparatively large area. Moreover, because of the mentioned difficulty of providing high resistance values, the cell will also absorb a rather high current.

Considering that a frequency reduction of one order of magnitude requires the use of three or four flip-flop cells, then this problem is further enhanced. A direct coupled triggered Flip-Flop including the features of the precharacterizing portion of claim 1 is known form US-A-3 767 943.

The main object of the invention is to provide a flip-flop frequency divider having a lower area and power drain than known frequency dividers.

According to one aspect of the invention, the above object, as well as other objects and advantages which will become more apparent hereinafter, are achieved by a frequency divider cell for IC's, as defined in claim 1.

The invention will be disclosed hereinafter in a more detailed way with reference to a preferred embodiment thereof, whicn is illustrated in the accompanying drawings, where:
figure 1 is a circuit diagram of a prior art master-slave flip-flop cell;
figure 2 is a circuit diagram of a preferred embodiment of a master-slave flip-flop cell according to the invention.

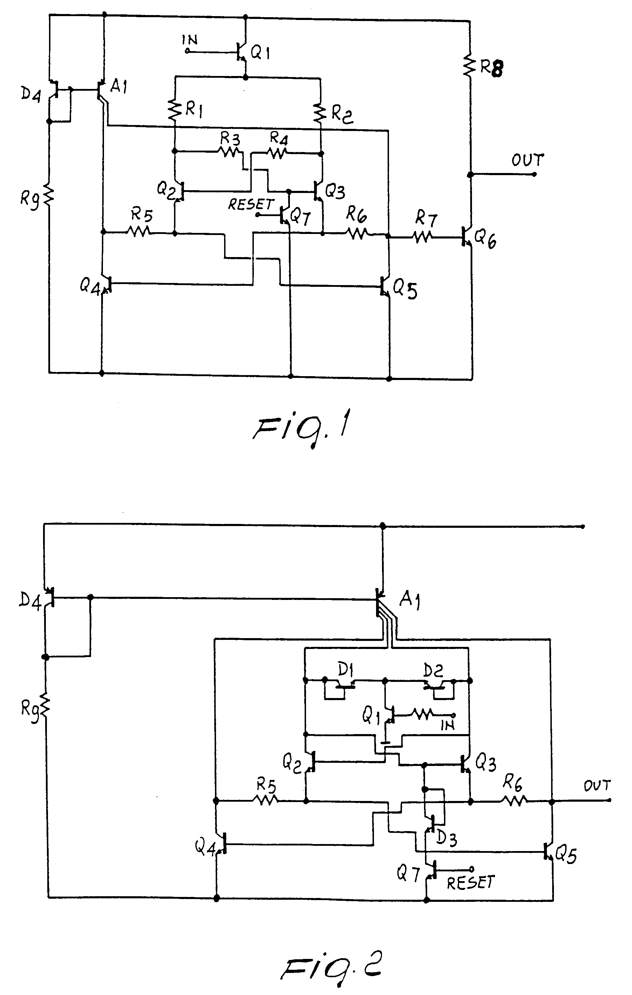

Figure 1 schematically illustrates a prior art frequency divider cell. The transistors Q2 and Q3, together with the load resistors R1, R2 and coupling resistors R3, R4 form the master or driving flip-flop, supplied through a transistor Q1 the base electrode of which forms the input pin IN of the cell. The transistors Q4 and Q5 together with the coupling resistors R5, R6 form the slave or storage flip-flop. The circuit elements A1, D4, R9 constitute a power supply that feed the slave flip-flop. The transistor Q6, controlled by the slave flip-flop through the resistor R7, forms a level shifter which supplies its output signal on the pin OUT, with such a level that it is able of directly driving the pin IN of a subsequent cell.

With reference to the circuit of fig. 1, as the input signal on the base IN of the transistor Q6 is at a low level, Q1 is off and the driving flip-flop comprising the two transistors Q2 and Q3 is disabled. The storage flip-flop Q4, Q5 will have a configuration which will depend on the past history, e.g with Q4 being on and Q5 off, and hence with a high level output.

As the input signal goes from low to high, the driving or control flip-flop is energized and one of the transistors Q2, Q3 turns on. Since the emitter electrode of Q2 is coupled to the base electrode of Q5, which is off, Q2 will be turned on before Q3 and the cross-coupling will cause Q3 to be held in an off state as far as Q2 is on. If Q2 is on, Q5 must be also on and Q4 off.

During the subsequent switching from high to low of the input signal, the above described situation will be repeated again; that is, the control flip-flop will be deactivated, whereas the storage flip-flop will not change its status. In the following transition, Q3 will be turned on before Q2 (since its emitter electrode is coupled to the base electrode of Q4 which is off), and accordingly it will cause the storage flip-flop to toggle. Thus the latter will change its status one time for any pair of transitions of the input signal and its output signal will have accordingly a frequency which is a half of the input signal frequency.

Figure 2 shows a circuit diagram of a master-slave cell according to the invention. This cell still comprises a pair of master transistors Q2, Q3 the emitter electrodes of which are coupled to the base electrodes of the slave transistor pair Q4, Q5. In this case, however, the power supply A1, D4, R9 feeds both transistor pairs. This will limit the current through the master pair legs and greatly reduce the cell power drain. Moreover the collector electrode of the transistor Q1, having its emitter electrode coupled to the ground, is coupled to the collector electrodes of Q2 and Q3, through the diodes D1 and D2, which provide voltage de-coupling of the two legs of the control transistor pair, as Q1 is off, and allow for the control transistor pair to be turned off as Q1 is on.

It should be easily apparent that the disclosed circuit operates in a manner analogous to that of the prior art, while having a lower number of components and a lower power drain.

In fact in order to control Q1, a voltage corresponding to V_{be} is now required (differently from the prior art) and accordingly it will be not necessary to provide an output level shifter stage, since the output signal can be directly taken from the collector of Q5. Thus the component elements Q6, R7, R8 of figure 1 can be omitted.

It should be also apparent that the circuit according to the invention also affords the possibility of reducing the number of the cell elements, thereby reducing the occupied silicon area as well as the consumed current.

While the invention has been disclosed with reference to a preferred embodiment, it should be apparent that it is susceptible to several modifications and variations all within the scope of the invention as defined in the accompanying claims.

Where technical features mentioned in any claim are followed by reference signs, those reference signs have been included for the sole purpose of increasing the intelligibility of the claims and accordingly, such reference signs do not have any limiting effect on the scope of the claim.

## Claims

1. A frequency divider cell for integrated circuits comprising:
- a power supply (A1, D4, R9);
- a control transistor pair (Q2, Q3), each control transistor having a collector, an emitter and a base electrode,
- the collector electrodes of said control transistors (Q2, Q3) being coupled to said power supply (A1, D4, R9),
- the collector and base electrodes of said control transistors (Q2, Q3) being cross-coupled;
- a storage transistor pair (Q4, Q5), each storage transistor having a collector, an emitter and a base electrode,
- the collector electrodes of said storage transistors (Q4, Q5) being coupled to said power supply (A1, D4, R9),
- the emitter electrodes of said storage transistors (Q4, Q5) being grounded,
- the base electrodes of said storage transistors (Q4, Q5) being cross-coupled to the emitter electrodes of said control transistors (Q2, Q3),
- an output pin (OUT) defined by the collector of one (Q5) of said storage transistors (Q4, Q5); and
- a command transistor (Q1) having:
- a grounded emitter electrode,
- a collector electrode operatively coupled to the collector electrodes of said control transistors (Q2, Q3)
- a base electrode operating as an input pin (IN) of the frequency divider cell,
CHARACTERIZED IN THAT said frequency divider cell further comprises:
- two diodes (D1, D2) coupled back to back in series between the collector electrodes of said control transistors (Q2, Q3), the collector electrode of said command transistor (Q1) being connected to the common coupling point of said two diodes (D1, D2);
- a reset transistor (Q7) having:
- a grounded emitter,
- a base operating as a control pin (RESET), and
- a collector; and
- a third diode (D3) coupled between said collector of said reset transistor (Q7) and the base electrode of one (Q3) of said control transistors (Q2, Q3);
- the collector and base electrodes of said storage transistors (Q4, Q5) being cross-coupled through respective resistors (R5, R6), said resistors (R5, R6) also connecting each emitter electrode of said control transistors (Q2, Q3) with the collector electrodes of said storage transistors (Q4, Q5).

2. A frequency divider cell according to claim 1, characterized in that each of said two diodes (D1, D2) consists of a transistor having an emitter, a collector and a base coupled to said collector, the collectors being each coupled to the collector electrodes of one of said control transistors (Q2, Q3).

3. A frequency divider cell according to either of claims 1 or 2, characterized in that said cross-coupling between said control transistors (Q2, Q3) and said storage transistors (Q4, Q5) and said cross-coupling between the collector and base electrodes of said control transistors (Q2, Q3) are short circuit couplings.

## Patentansprüche

1. Frequenzteilerzelle für integrierte Schaltungen enthaltend:
- eine Stromversorgung (A1, D4, R9);
- ein Steuertransistorpaar (Q2, Q3), wobei jeder Steuertransistor eine Kollektor-, eine Emitter- und eine Basiselektrode aufweist und
- die Kollektorelektroden der Steuertransistoren (Q2, Q3) an die Stromversorgung (Al, D4, R9) angeschlossen sind, während
die Kollektor- und Basiselektroden der Steuertransistoren (Q2, Q3) über Kreuz verbunden sind;
- ein Speichertransistorpaar (Q4, Q5), wobei jeder Speichertransistor eine Kollektor-, eine Emitter- und eine Basiselektrode aufweist und
- die Kollektorelektroden der Speichertransistoren (Q4, Q5) an die Stromversorgung (A1, D4, R9) angeschlossen sind.
- die Emitterelektroden der Speichertransistoren (Q4, Q5) an Masse gelegt sind, und
- die Basiselektroden der Speichertransistoren (Q4, Q5) über Kreuz mit den Emitterelektroden der Steuertransistoren (Q2, Q3) verbunden sind;
- einen Ausgangsanschlußstift (OUT), der durch den Kollektor eines (Q5) der Speicher transistoren (Q4, Q5) gebildet ist; und
- einen Befehlstransistor (Q1) mit
- einer an Masse gelegten Emitterelektrode,
einer operativ an die Kollektorelektroden der Steuertransistoren (Q2, Q3) angeschlossenen Kollektorelektrode, und
- einer als Eingangsanschlußstift (IN) der Frequenzteilerzelle funktionierenden Basiselektrode;
dadurch gekennzeichnet, daß die Frequenzteilerzelle weiterhin enthält:
- zwei Dioden (D1, D2), die gegeneinander in Reihe zwischen die Kollektorelektroden der Steuertransistoren (Q2, Q3) geschaltet sind, wobei die Kollektorelektrode des Befehlstransistors (Q1) an den gemeinsamen Verbindungspunkt der beiden Dioden (D1, D2) angeschlossen ist;
- einen Rücksetztransistor (Q7) mit:
- einem an Masse gelegten Emitter,
- einer als Steueranschlußstift (RESET) funktionierenden Basis und
- einem Kollektor; und
- eine dritte Diode (D3), die zwischen dem Kollektor des Rücksetztransistors (Q7) und die Basiselektrode eines (Q3) der Steuertransistoren (Q2, Q3) angeschlossen ist, wobei die Kollektor- und Basiselektroden der Speichertransistoren (Q4, Q5) über entsprechende Widerstände (R5, R6) über Kreuz verbunden sind und diese Widerstände (R5, R6) auch die jeweiligen Emitterelektroden der Steuertransistoren (Q2, Q3) mit den Kollektorelektroden der Speichertransistoren (Q4, Q5) verbinden.

2. Frequenzteilerzelle nach Anspruch 1, dadurch gekennzeichnet, daß die beiden Dioden (D1, D2) aus einem Transistor mit einem Emitter, einem Kollektor und einer mit dem Kollektor verbundenen Basis bestehen und die jeweiligen Kollektoren an die Kollektorelektroden jeweils eines der Steuertransistoren (Q2, Q3) angeschlossen sind.

3. Frequenzteilerzelle nach Anspruch 1 oder 2, dadurch gekennzeichnet, daß die Kreuzverbindungen zwischen den Steuertransistoren (Q2, Q3) und den Speichertransistoren (Q4, Q5) und die Kreuzverbindungen zwischen den Kollektor- und Basiselektroden der Steuertransistoren (Q2, Q3) Kurzschlußverbindungen sind.

## Revendications

1. Cellule de diviseur de fréquence pour circuits intégrés comprenant :
une alimentation de puissance (A1, D4, R9) ;
une paire de transistors de commande (Q2, Q3), chaque transistor de commande ayant une électrode de collecteur, une électrode d'émetteur et une électrode de base,
- les électrodes de collecteur des transistors de commande (Q2, Q3) étant couplées à l'alimentation de puissance (A1, D4, R9),
- les électrodes de collecteur et de base des transistors de commande (Q2, Q3) étant couplées de façon croisée ;
une paire de transistors de mémorisation (Q4, Q5), chaque transistor de mémorisation ayant une électrode de collecteur, une électrode d'émetteur et une électrode de base,
- les électrodes de collecteur des transistors de mémorisation (Q4, Q5) étant couplées à l'alimentation de puissance (A1, D4, R9),
- les électrodes d'émetteur des transistors de mémorisation (Q4, Q5) étant à la masse,
- les électrodes de base des transistors de mémorisation (Q4, Q5) étant couplées de façon croisée avec les électrodes d'émetteur des transistors de commande (Q2, Q3),
une borne de sortie (OUT) définie par le collecteur de l'un (Q5) des transistors de mémorisation (Q4, Q5) ; et
un transistor de validation (Q1) ayant :
- une électrode d'émetteur mise à la masse,
- une électrode de collecteur couplée opérativement aux électrodes de collecteur des transistors de commande (Q2, Q3),
- une électrode de base fonctionnant comme borne d'entrée (IN) de la cellule de diviseur de fréquence,
caractérisée en ce que la cellule de diviseur de fréquence comprend en outre :
deux diodes (D1, D2) couplées dos à dos en série entre les électrodes de collecteur des transistors de commande (Q2, Q3), l'électrode de collecteur du transistor de validation (Q1) étant connectée au point de connexion des deux diodes (D1, D2) ;
un transistor de remise à zéro (Q7) comportant :
- un émetteur mis à la masse,
- une base fonctionnant comme borne de commande (RESET), et
- un collecteur ; et
une troisième diode (D3) couplée entre le collecteur du transistor de remise à zéro (Q7) et l'électrode de base de l'un (Q3) des transistors de commande (Q2, Q3) ;
les électrodes de collecteur et de base des transistors de mémorisation (Q4, Q5) étant couplées de façon croisée par l'intermédiaire de résistances respectives (R5, R6), les résistances (R5 et R6) connectant également chaque électrode d'émetteur des transistors de commande (Q2, Q3) aux électrodes de collecteur des transistors de mémorisation (Q4, Q5).

2. Cellule de diviseur de fréquence selon la revendication 1, caractérisée en ce que chacune des deux diodes (D1, D2) consiste en un transistor ayant un émetteur, un collecteur et une base couplée au collecteur, chacun des collecteurs étant couplé à l'électrode de collecteur de l'un des transistors de commande (Q2, Q3).

3. Cellule de diviseur de fréquence selon la revendication 1 ou 2, caractérisée en ce que le couplage croisé entre les transistors de commande (Q2, Q3) et les transistors de mémorisation (Q4, Q5) et le couplage croisé entre les électrodes de collecteur et de base des transistors de commande (Q2, Q3) sont des couplages en court-circuit.
